(19) Europäisches Patentamt
European Patent Office
Office européen des brevets

(11) **EP 1 530 801 B1**

(12) **EUROPÄISCHE PATENTSCHRIFT**

(45) Veröffentlichungstag und Bekanntmachung des Hinweises auf die Patenterteilung:
**03.02.2010 Patentblatt 2010/05**

(21) Anmeldenummer: 03792392.7

(22) Anmeldetag: **20.08.2003**

(51) Int Cl.:
***H01L 23/31*** *(2006.01)*   ***H01L 23/485*** *(2006.01)*

(86) Internationale Anmeldenummer:
**PCT/EP2003/009227**

(87) Internationale Veröffentlichungsnummer:
**WO 2004/019405 (04.03.2004 Gazette 2004/10)**

(54) **HALBLEITERBAUELEMENT MIT CSP-GEHÄUSE**

SEMICONDUCTOR COMPONENT HAVING A CSP HOUSING

COMPOSANT A SEMI-CONDUCTEURS A BOITIER CSP

(84) Benannte Vertragsstaaten:
**DE FR GB IE IT**

(30) Priorität: **22.08.2002 DE 10238581**

(43) Veröffentlichungstag der Anmeldung:
**18.05.2005 Patentblatt 2005/20**

(73) Patentinhaber: **Qimonda AG**
**81739 München (DE)**

(72) Erfinder:
• **HEDLER, Harry**
**82110 Germering (DE)**
• **MEYER, Thorsten**
**01099 Dresden (DE)**
• **VASQUEZ, Barbara**
**Walden, CO 80480 (US)**

(74) Vertreter: **Barth, Stephan Manuel**
**Reinhard, Skuhra, Weise & Partner GbR**
**Patent- und Rechtsanwälte**
**Friedrichstrasse 31**
**80801 München (DE)**

(56) Entgegenhaltungen:
**DE-A- 10 016 132    US-A1- 2002 027 298**
**US-A1- 2002 034 872    US-A1- 2002 038 890**

• **PATENT ABSTRACTS OF JAPAN vol. 2000, no. 25, 12. April 2001 (2001-04-12) -& JP 2001 210760 A (TOPPAN PRINTING CO LTD), 3. August 2001 (2001-08-03)**
• **PATENT ABSTRACTS OF JAPAN vol. 2000, no. 25, 12. April 2001 (2001-04-12) -& JP 2001 237351 A (HITACHI MAXELL LTD), 31. August 2001 (2001-08-31)**

**Beschreibung**

Die Erfindung betrifft ein Halbleiterbauelement zur Montage auf einer Leiterplatte, wobei das Halbleiterbauelement ein Gehäuse umfasst, welches Gehäuse wenigstens teilweise umgibt, wobei dem Halbleiterchip elektrische Kontakte zugeordnet sind, vermittels welcher eine elektrische Verbindung mit auf der Leiterplatte vorgesehenen Elektroden oder Elektrodenflächen hergestellt werden soll.

Aus US 2002/034872 A1 ist ein Halbleiterbauelement mit einem Gehäuse, einem innenliegenden Chip, der Kontakte an einer Kontaktfläche und eine Abstützfläche aufweist, bekannt. Ferner ist eine Pufferschicht zwischen dem Gehäuse und dem Chip vorgesehen. Weitere Halbleiterbauelemente dieser Gestalt sind aus den Druckschriften US 2002/038890 A1 und JP 2001 210760 A bekannt.

Unter anderem aus der US 2002/027298 A1 ist es bekannt Halbleiterchips vollständig in ein Gehäuse einzubetten.

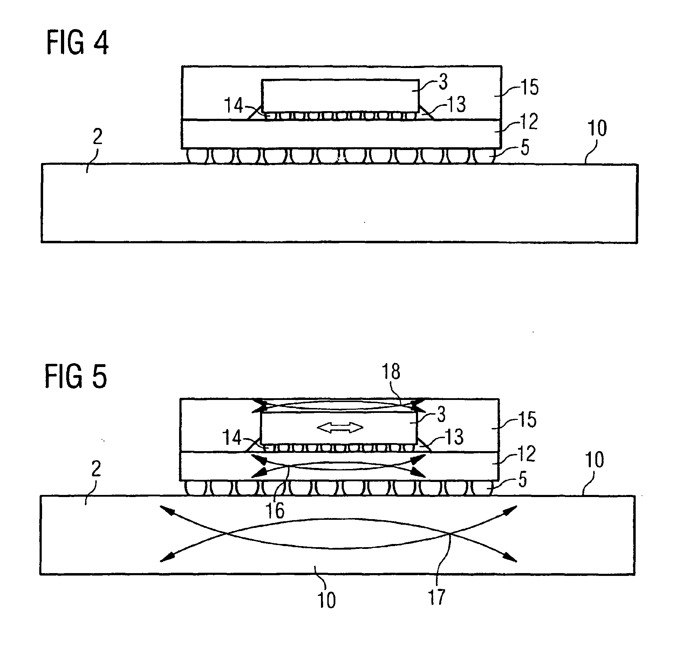

Bei hochintegrierten und stark miniaturisierten Halbleiterbauelementen tritt nach deren Montage auf gedruckten Schaltungen (Leiterplatten) verstärkt das Problem auf, dass bei Temperaturschwankungen aufgrund der unterschiedlichen Temperaturausdehnungskoeffizienten der beteiligten Materialen starke mechanische Spannungen innerhalb des Bauelements und zwischen dem Bauelement und der Leiterplatte auftreten. Figur 4 zeigt eine übliche Bauform eines solchen miniaturisierten Halbleiterbausteins. Das Halbleiterbauelement 1 ist mit seinen elektrischen Kontakten 5 mit der Leiterplatte 2 verbunden. Das Halbleiterchip 3 wiederum ist mittels elektrischer Kontakte 14 mit dem Zwischenstück 12 ("interposer") verbunden, wobei das Halbleiterchip mittels einer Unterfüllung 13 ("underfiller") mit dem Zwischenstück zur mechanischen Stabilisierung verklebt ist. Das Halbleiterchip 3 ist weiterhin mit einer Umhüllung 1 vergossen. Das Zwischenstück 12 ist als Träger auch oftmals vollständig mit vergossen.

Infolge von Temperaturschwankungen oder -veränderungen treten in den bekannten Bauelementformen mechanische Spannungen auf Grund der unterschiedlichen Temperaturausdehnungskoeffizienten der verschiedenen Materialien auf. Figur 5 verdeutlicht dies näher. Das Halbleiterchip 3 hat einen geringeren Temperaturausdehnungskoeffizienten $\alpha$ als das Zwischenstück 12, das aus einem anderen Material gefertigt ist. Aufgrund der unterschiedlichen Ausdehnung des Halbleiterchips und des Zwischenstücks wird über die zur mechanischen Fixierung und Stabilisierung notwendige Unterfüllung 13 eine starke mechanische Spannung 16 übertragen und in dem Zwischenstück 12 erzeugt. Damit hier nicht ein Verbindungsbruch der elektrischen Kontakte 14 entsteht, muss der Temperaturausdehnungskoeffizient des Zwischenstücks schon an das Halbleiterchip angepasst sein. Üblicherweise Verwendung findende Leiterplatten 2 haben jedoch einen von Halbleiterchips stark unterschiedlichen Temperaturausdehnungskoeffizienten. Daher wird vom, schon unter mechanischer Spannung stehenden, Zwischenstück 12 über die damit strapazierten elektrischen Kontakte 5 eine starke mechanische Spannung 17 auf die Leiterplatte 2 ausgeübt. Im Extremfall kann diese starke mechanische Verspannung zu einer Verformung der Leiterplatte führen, was insbesondere bei einer doppelseitigen Bestückung von Leiterplatten zum Bruch von elektrischen Kontakten 5 und damit zur Zerstörung des elektronischen Gerätes führen kann. Führt die Verformung nicht gleich zum Bruch, dann jedoch im Verlauf von vielen Ver- und Entspannungen zur Ermüdung des Materials der elektrischen Kontakte 5, was dann wieder letztendlich zum Bruch derselben führt und die Lebensdauer begrenzt. Auch führt die starke unterschiedliche Ausdehnung, und damit die mechanische Verspannung, des Halbleiterbauelements in sich selber, also einerseits zwischen Halbleiterchip und Zwischenstück, und Halbleiterchip und Umhüllung - in welcher wieder eine Verspannung 18 induziert wird - andererseits, zur Ermüdung der elektrischen Kontakte 14, wodurch auch eine Zerstörung der elektrischen Kontakte innerhalb der Halbleiterbauelemente 1 erfolgen kann.

Ein direktes Aufsetzen eines Halbleiterchips lediglich über Bumps auf eine Leiterplatte, um mechanische Spannungen oder Übertragungen derselben von dazwischen gelagerten Schichten zu verhindern, führt auch nicht zum Ziel, da hierdurch keine dauerhaft stabile mechanische Verbindung zwischen dem Halbleiterchip und der Leiterplatte erzeugt werden kann. Auch ein Aufkleben eines Chips über Bumps mit einer Unterfüllung ("underfiller"), beispielsweise in Form eines Epoxy-Klebstoffes, würde hier nur die direkten Verspannungen vom Halbleiterchip zur Leiterplatte führen. Hierdurch würde sich die Leiterplatte wiederum verformen, mit den oben genannten Schwierigkeiten. Insbesondere würde es, bei beidseitig bestückten Leiterplatten, zu einer Zerstörung von auf einer Seite einer Leiterplatte befindlichen Schaltungen oder deren elektrischer Kontakte führen.

Damit dennoch ausreichend langlebige elektronische Schaltungen hergestellt werden können, sind aufwendige und damit teure Gehäusekonstruktionen für Halbleiterbauelemente notewendig.

Aufgabe der Erfindung ist es daher, ein Halbleiterbauelement zur Verfügung zu stellen, bei denen die oben genannten Nachteile nicht auftreten und bei dem dennoch die sehr kompakte Bauform ermöglicht ist.

Diese Aufgabe wird durch die kennzeichnenden Merkmale des Anspruchs 1 gelöst.

Erfindungsgemäß ist vorgesehen, dass das flächige Halbleiterchip eine Montageseitenfläche aufweist, wobei an der Montageseitenfläche elektrische Kontaktflächen zum Kontakt mit den elektrischen Kontakten vorgesehen sind, wobei das Halbleiterchip bis auf eine auf der Montageseitenfläche angeordnete Abstützfläche von einer Pufferschicht umgeben ist, welche sich zwischen dem Gehäuse und der Halbleiterchip befindet, welche Abstützfläche wesentlich kleiner als die Montageseitenfläche ist.

Die Erfindung schlägt vor, das Halbleiterchip mittels der kleinen Abstützfläche und dem damit geringem räumlichen Kontakt zu Materialien mit ungünstigem Temperaturausdehnungskoeffizienten sozusagen zu entkoppeln, wodurch das Halbleiterchip sich innerhalb des Gehäuses geringer oder mehr ausdehnen kann, als es das umgebende Gehäuse oder die Leiterplatte tut, auf der das Halbleiterbauelement befestigt ist, ohne mechanische Spannungen hervorzurufen. Eine mechanische Stabilisierung des Chips ist dabei in seiner Position auf der Leiterplatte durch das Gehäuse sicher gestellt. Hierdurch wird eine Anpassung an die thermomechanischen Eigenschaften von Leiterplattenmaterial ermöglicht, was eine dauerhafte, verspannungsfreie Verbindung zwischen Leiterplatte (beispielsweise gedruckte Schaltung) und Halbleiterbauelement ermöglicht.

Eine bevorzugte Ausgestaltung der Erfindung sieht vor, dass das Halbleiterchip sich mechanisch auf einem aus dem Gehäuse ausgeformten Stützsockel auf der auf der Montageseitenfläche angeordneten Abstützfläche abstützt.

Bevorzugterweise ist das Halbleiterchip mechanisch, fest mit einem aus dem Gehäuse ausgeformten Stützsockel an der auf der Montageseitenfläche angeordneten Abstützfläche verbunden.

Von Vorteil ist die Abstützfläche zentral in der Montageseitenfläche angeordnet.

Eine bevorzugte Ausgestaltung der Erfindung sieht vor, das Halbleiterbauelement in WLP- ("wafer level package"), in Flip-Chip- oder in CSP-Bauweise ("chip scale package") gefertigt ist.

Von Vorteil sind die elektrischen Kontakte durch Bumps ausgebildet.

Erfindungsgemäß beträgt der Durchmesser G der Pufferschicht zwischen dem Gehäuse einer Seitenfläche des Halbleiterchips

$$G := C \cdot \frac{\alpha_F - \alpha_C}{\alpha_G - \alpha_F},$$

wobei G der Durchmesser der Pufferschicht zwischen dem Gehäuse und einer Seitenfläche des Halbleiterchips ist, C die Länge des Lotes von der Seitenfläche zum Mittelpunkt des Halbleiterchips ist, $\alpha_C$ der Temperatur-Ausdehnungskoeffizient des Halbleiterchips ist, $\alpha_G$ der Temperatur-Ausdehnungskoeffizient der Pufferschicht ist und $\alpha_F$ der Temperatur-Ausdehnungskoeffizient des Gehäuses ist.

Ebenso von Vorteil ist gemäß einer Ausgestaltung der Erfindung vorgesehen, dass das Material der Pufferschicht so gewählt ist, dass der Temperatur-Ausdehnungskoeffizient der Pufferschicht größer als der Temperatur-Ausdehnungskoeffizient von solchem Leiterplattenmaterial ist, auf dem das Halbleiterbauelement befestigt werden soll. Dem folgend ist das Material so gewählt, dass die Pufferschicht den niedrigeren Temperatur-Ausdehnungskoeffizienten vom Halbleitermaterial, beispielsweise Silizium des Halbleiterchips so entspricht, dass beide zusammen dem Temperatur-Ausdehnungskoeffizienten vom Gehäuse bzw. der Leiterplatte entsprechen.

Dem folgend, ist nach einer Ausgestaltung der Erfindung vorgesehen, dass die Pufferschicht hochelastisch ist.

Das Material des Gehäuses ist nach einer bevorzugten Ausgestaltung der Erfindung so gewählt ist, dass der Temperatur-Ausdehnungskoeffizient des Gehäuses gleich dem von solchem Leiterplattenmaterial ist, auf dem das Halbleiterbauelement befestigt werden soll.

Gemäß einer besonders bevorzugten Ausgestaltung der Erfindung ist vorgesehen, dass das Material des Gehäuses so gewählt ist, dass der Temperatur-Ausdehnungskoeffizient des Gehäuses größer als der des Halbleiterchips ist.

Dem folgend ist gemäß einer Ausgestaltung der Erfindung vorgesehen, dass das Material der Pufferschicht und des Halbleiterchips so gewählt ist, dass deren Temperatur-Ausdehnungskoeffizient zusammen gleich dem des Gehäuses und/oder dem von solchem Leiterplattenmaterial ist, auf dem das Halbleiterbauelement befestigt werden soll.

Weitere Vorteile, Besonderheiten und zweckmäßige Weiterbildungen der Erfindung ergeben sich aus den weiteren Unteransprüchen oder deren Unterkombinationen.

Nachfolgend wird die Erfindung anhand der Zeichnung weiter erläutert.

Dabei zeigt:

Fig. 1    ein erfindungsgemäßes Halbleiterbauelement zur Monta- ge auf einer Leiterplatte,

Fig. 2    ein erfindungsgemäßes Halbleiterbauelement nach einer zweiten Ausführung,

Fig. 3    das Halbleiterbauelement aus Figur 1 und 2 in Blick- richtung III

Fig. 4    ein herkömmliches Halbleiterbauelement auf einer Lei- terplatte montiert,

Fig. 5    eine schematische Darstellung von Verspannungen eines herkömmlichen Halbleiterbauelements auf einer Leiter- platte,

Fig. 6     eine Detailansicht des Halbleiterbauelements aus Fi- gur 1, und

Fig. 7     ein Diagramm der Dimensionierung der Elemente der Halbleiterbauelements.

In den Figuren gleiche Bezugszeichen bezeichnen gleiche oder gleich wirkende Elemente.

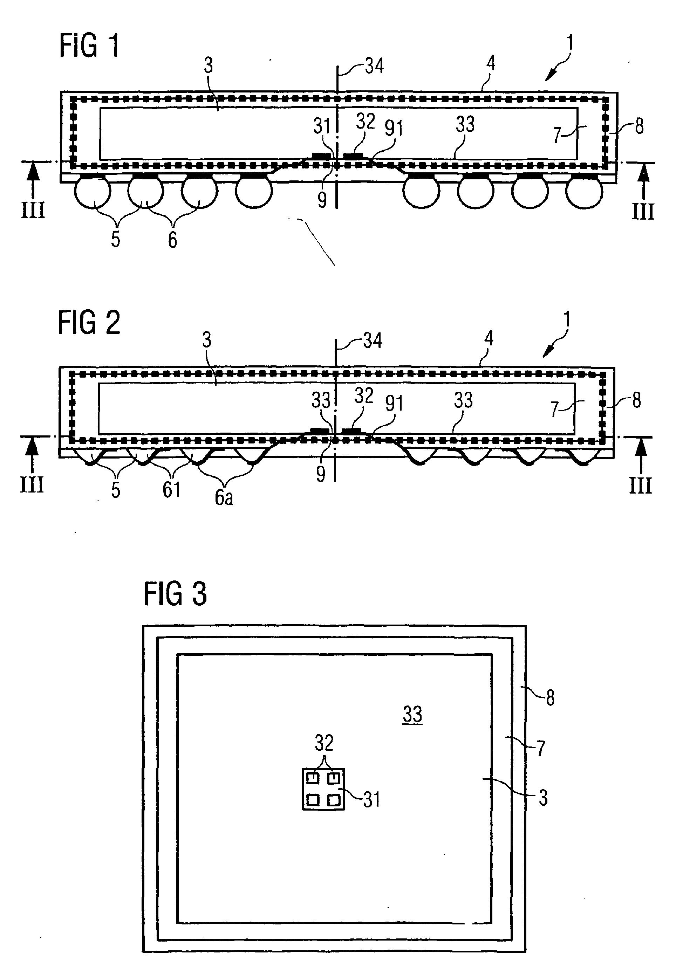

Die Figur 1 zeigt schematisch ein erfindungsgemäßes Halbleiterbauelement 1 zur Montage auf einer Leiterplatte. Das Halbleiterchip 3 wird dabei vollständig durch das Gehäuse 8 zum Schutz vor Außeneinwirkungen umhüllt. Innerhalb der Gehäuses 8 ist das Halbleiterchip 3 mit einer Pufferschicht 7 bis auf den Bereich der Abstützfläche 31 umgeben. Innerhalb der Abstützfläche 31 ist das Halbleiterchip 3 über elektrische Kontaktflächen 32 über Leitungszuführungen mit den elektrischen Kontakten 5 in Form von Bumps 6 (Lotbällchen, "solder bumps") verbunden, über welche die elektrische Kontaktierung mit den hierzu vorgesehenen Elektrodenflächen auf der Leiterplattenoberfläche der Leiterplatte (nicht dargestellt) erfolgt.

Das Halbleiterchip 3 selbst ist mit dem Gehäuse 8 mechanisch nur durch an der Abstützfläche 31 verbunden. Ansonsten ist das Halbleiterchip weich in der elastischen Pufferschicht gebettet, sodass eine Verspannung mit dem Gehäuse und dadurch bedingte Verformung der Außenmaße des Halbleiterbauelements nicht vorkommen kann.

Die unterschiedlichen Temperaturausdehnungskoeffizienten $\alpha$ von Halbleiterchip und Leiterplatte führen daher nicht zu Verspannungen, da die unterschiedliche Ausdehnung zwischen Leiterplatte und Halbleiterchip 3 über die ausreichend nachgiebige Pufferschicht 7 abgefangen wird. Die unterschiedliche Ausdehnung zwischen Halbleiterchip 3 und Gehäuse 8 belastet auch nicht mehr die inneren Kotakte 32, da durch die zentrale Anordnung der Kotakte in einem engen Bereich der Gesamtfläche des Chips eine temperaturbedingte Ausdehnung gegenüber dem Gehäuse nicht mehr zu Versetzungen führt. Eine Ermüdung der elektrischen Kontakte im Innern des Halbleiterbauelements wie auch Außen am Halbleiterbauelement wird hierdurch nicht mehr hervorgerufen. Die Lebensdauer ist deutlich erhöht.

Figur 2 zeigt ein anderes Ausführungsbeispiel eines Halbleiterbauelements 1, bei dem die elektrischen Kontakte durch sogenannte "Compliant Bumps" 61, also als nachgiebige Bumps ausgebildet sind. Dabei sind die eigentlichen Bumps 61 durch Silikon-Ausformungen gebildet, die im Beispiel zur Kontaktierung mit einem dünnen, hochflexiblen Metallstreifen 6a überzogen sind, um die elektrischen Kontakte zu ermöglichen.

Figur 3 zeigt eine Ansicht in Blickrichtung III aus Figur 1 und 2. Die Abstützfläche 31, innerhalb derer sich auch die elektrische Kontaktflächen 32 befinden, ist deutlich kleiner als die Montageseitenfläche 33 und befindet sich in deren Mitte.

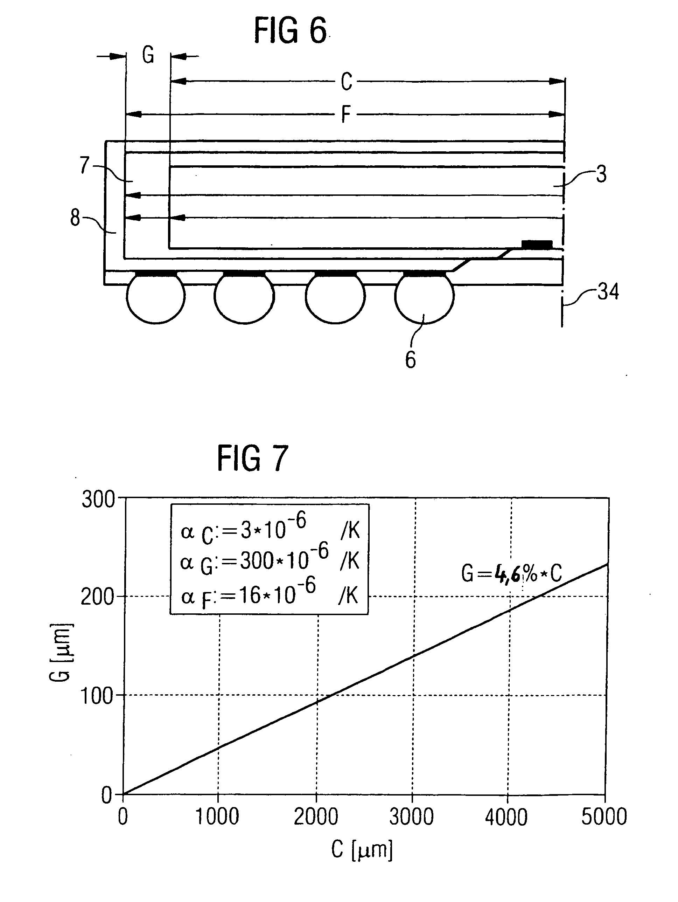

Figur 6 zeigt nochmals detaillierter einen Ausschnitt aus Figur 1, wobei die Dimensionierung der Schichtdicken nach der Beziehung

$$G := C \cdot \frac{\alpha_F - \alpha_C}{\alpha_G - \alpha_F},$$

bestimmt ist, wobei $\alpha_C$ der Temperatur-Ausdehnungskoeffizient des Halbleiterchips ist, $\alpha_G$ der Temperatur-Ausdehnungskoeffizient der Pufferschicht 7 ist und $\alpha_F$ der Temperatur-Ausdehnungskoeffizient des Gehäuses ist. C ist der Abstand von der Seitenfläche zur Mittelachse 34. Dabei stellt G den minimalen Wert dar.

Figur 7 zeigt beispielhaft ein Diagramm, in dem die Dicke G der Pufferschicht über dem halben Halbleiterchipdurchmesser C aufgetragen ist. Die Steigung von 4,6 % ergibt sich dabei aus den angenommenen Werten für die Temperatur-Ausdehnungskoeffizienten zu:

$$\alpha_C := 3 \cdot 10^{-6} \ /K$$

$$\alpha_G := 300 \cdot 10^{-6} \ /K$$

$$\alpha_F := 16 \cdot 10^{-6} \ /K .$$

Bezugzeichenliste

| 1 | Halbleiterbauelement |
|---|---|
| 2 | Leiterplatte |
| 3 | Halbleiterchip |
| 31 | Abstützfläche |
| 32 | elektrische Kontaktfläche |
| 33 | Montageseitenfläche |
| 34 | Mittelachse |
| 4, 8 | Gehäuse |
| 5 | elektrische Kontakte |
| 6 | Bumps |
| 61 | Compliant-Bumps |
| 6a | Metallstreifen |
| 7 | Pufferschicht |
| 9 | Stützsockel |
| 91 | Leitungszuführungen |
| 10 | Oberfläche der Leiterplatte |
| 12 | Zwischenstück |
| 13 | Unterfüllung |
| 14 | elektrische Kontakte |
| 15 | Umhüllung |
| 16 bis 18 | mechanische Spannung |

**Patentansprüche**

1.  Halbleiterbauelement (1) zur Montage auf einer Leiterplatte, wobei das Halbleiterbauelement ein flächig ausgebildetes Halbleiterchip (3) aufweist,
    wobei dem Halbleiterchip elektrische Kontakte (5) zugeordnet sind, mittels welcher eine elektrische Verbindung mit auf der Leiterplatte vorgesehenen Elektroden oder Elektrodenflächen hergestellt werden soll,
    wobei das flächige Halbleiterchip (3) eine Montageseitenfläche (33) aufweist, wobei auf der Montageseitenfläche (33) eine Abstützfläche (31) angeordnet ist, die wesentlich kleiner als die Montageseitenfläche (33) ist, und innerhalb der Abstützfläche (31) an der Montageseitenfläche (33) elektrische Kontaktflächen (32) zum Kontakt mit den elektrischen Kontakten (5) vorgesehen sind,
    wobei das Halbleiterbauelement (1) ein Gehäuse (8) aufweist, wobei das Halbleiterbauelement (1) eine Pufferschicht (7) zwischen dem Gehäuse (8) und dem Halbleiterchip (3) aufweist,
    **dadurch gekennzeichnet,**
    **dass** das Gehäuse (8) das Halbleiterchip (3) vollständig umgibt und die Pufferschicht (7) das Halbleiterchip (3) bis auf den Bereich der Abstützfläche (31) umgibt und
    ein Durchmesser G der Pufferschicht (7) zwischen dem Gehäuse (8) einer Seitenfläche des Halbleiterchips (3)

$$G := C \cdot \frac{\alpha_F - \alpha_C}{\alpha_G - \alpha_F}$$

    beträgt, wobei G der Durchmesser der Pufferschicht (7) zwischen dem Gehäuse (8) und einer Seitenfläche des Halbleiterchips (3), C die Länge des Lotes von der Seitenfläche zum Mittelpunkt des Halbleiterchips (3), $\alpha_C$ der Temperatur-Ausdehnungskoeffizient des Halbleiterchips (3), $\alpha_G$ der Temperatur-Ausdehnungskoeffizient der Pufferschicht (7) und $\alpha_F$ der Temperatur-Ausdehnungskoeffizient des Gehäuses (8) ist.

2.  Halbleiterbauelement nach Anspruch 1,
    **dadurch gekennzeichnet,**
    **dass** das Halbleiterchip (3) sich mechanisch auf einem aus dem Gehäuse (8) ausgeformten Stützsockel (9) auf der auf der Montageseitenfläche (33) angeordneten Abstützfläche (31) abstützt.

**3.** Halbleiterbauelement nach Anspruch 1 oder 2,
**dadurch gekennzeichnet,**
**dass** das Halbleiterchip (3) mechanisch fest mit einem aus dem Gehäuse (8) ausgeformten Stützsockel (9) an der auf der Montageseitenfläche (33) angeordneten Abstützfläche (31) verbunden ist und der Sockel zur Zuführung von Leitungszuführungen (91) von den elektrischen Kontakten (5, 6, 61) zu den elektrischen Kontaktflächen (32) dient.

**4.** Halbleiterbauelement nach einem der Ansprüche 1 bis 3,
**dadurch gekennzeichnet,**
**dass** die Abstützfläche (31) zentral in der Montageseitenfläche (33) angeordnet ist.

**5.** Halbleiterbauelement nach einem der Ansprüche 1 bis 3,
**dadurch gekennzeichnet,**
**dass** die Abstützfläche (31) am geometrischen Schwerpunkt der Montageseitenfläche (33) angeordnet ist.

**6.** Halbleiterbauelement nach einem der vorhergehenden Ansprüche,
**dadurch gekennzeichnet,**
**dass** die elektrischen Kontakte (5) durch Bumps (6) ausgebildet sind.

**7.** Halbleiterbauelement nach einem der vorhergehenden Ansprüche,
**dadurch gekennzeichnet,**
**dass** die Bumps (6) Lotbällchen sind.

**8.** Halbleiterbauelement nach einem der Ansprüche 1 bis 6,
**dadurch gekennzeichnet,**
**dass** die Bumps (6) Silikonkügelchen mit darüber geführten elektrischen Leitflächen (6a) zur Kontaktierung oder elektrisch leitende im wesentlichen aus Silikon bestehende Kügelchen sind.

**9.** Halbleiterbauelement nach einem der vorhergehenden Ansprüche in Verbindung mit einer Leiterplatte,
**dadurch gekennzeichnet,**
**dass** das Material der Pufferschicht (7) so gewählt ist, dass der Temperatur-Ausdehnungskoeffizient der Pufferschicht größer als der Temperatur-Ausdehnungskoeffizient von solchem Leiterplattenmaterial ist, auf dem das Halbleiterbauelement (1) befestigt verden soll.

**10.** Halbleiterbauelement nach einem der vorhergehenden Ansprüche,
**dadurch gekennzeichnet,**
**dass** die Pufferschicht (7) hochelastisch ist.

**11.** Halbleiterbauelement nach einem der Ansprüche 9 oder 10, wenn Anspruch 10 sich auf Anspruch 9 rückbezieht,
**dadurch gekennzeichnet,**
**dass** das Material des Gehäuses (8) so gewählt ist, dass der Temperatur-Ausdehnungskoeffizient des Gehäuses gleich dem von solchem Leiterplattenmaterial ist, auf dem das Halbleiterbauelement (1) befestigt worden soll.

**12.** Halbleiterbauelement nach einem der vorhergehenden Ansprüche,
**dadurch gekennzeichnet,**
**dass** das Material des Gehäuses (8) so gewählt ist, dass der Temperatur-Ausdehnungskoeffizient des Gehäuses größer als der des Halbleiterchips (3) ist.

**13.** Halbleiterbauelement nach einem der vorhergehenden Ansprüche,
**dadurch gekennzeichnet,**
**dass** die Pufferschicht (7) aus einem Polymer, insbesondere Silikon oder Polyurethan besteht.

**14.** Halbleiterbauelement nach Anspruch 13,
**dadurch gekennzeichnet,**
**dass** die Pufferschicht (7) aus einem aufgeschäumten Material besteht.

**Claims**

1. Semiconductor component (1) for mounting on a printed circuit board, the semiconductor component having a semiconductor chip (3) formed in planar fashion, the semiconductor chip being assigned electrical contacts (5) by means of which an electrical connection to electrodes or electrode areas provided on the printed circuit board is to be produced,
   the planar semiconductor chip (3) having a mounting side area (33), a supporting area (31) being arranged on the mounting side area (33), the supporting area (31) being significantly smaller than the mounting side area (33), and electrical contact areas (32) for contact with the electrical contacts (5) being provided within the supporting area (31) on the mounting side area (33),
   the semiconductor component (1) having a housing (8) the semiconductor component (1) having a buffer layer (7) between the housing (8) and the semiconductor chip (3)
   **characterized**
   **in that** the housing (8) completely surrounds the semiconductor chip (3) and the buffer layer (7) surrounds the semiconductor chip (3) except for the region of the supporting area (31), and a diameter G of the buffer layer (7) between the housing (8) of a side area of the semiconductor chip (3) is

$$G := C \cdot \frac{\alpha F - \alpha C}{\alpha G - \alpha F}$$

   where G is the diameter of the buffer layer (7) between the housing (8) and a side area of the semiconductor chip (3), C is the length of the solder from the side area to the central point of the semiconductor chip (3), $\alpha_C$ is the thermal expansion coefficient of the semiconductor chip (3), $\alpha_G$ is the thermal expansion coefficient of the buffer layer (7) and $\alpha_F$ is the thermal expansion coefficient of the housing (8).

2. Semiconductor component according to Claim 1,
   **characterized**
   **in that** the semiconductor chip (3) is mechanically supported on a support base (9) shaped from the housing (8) on the supporting area (31) arranged on the mounting side area (33).

3. Semiconductor component according to Claim 1 or 2,
   **characterized**
   **in that** the semiconductor chip (3) is mechanically fixedly connected to a support base (9) shaped from the housing (8) on the supporting area (31) arranged on the mounting side area (33), and the base serves for feeding line feeds (91) from the electrical contacts (5, 6, 61) to the electrical contact areas (32).

4. Semiconductor component according to one of Claims 1 to 3,
   **characterized**
   **in that** the supporting area (31) is arranged centrally in the mounting side area (33).

5. Semiconductor component according to one of Claims 1 to 3,
   **characterized**
   **in that** the supporting area (31) is arranged at the geometric centroid of the mounting side area (33).

6. Semiconductor component according to one of the preceding claims,
   **characterized**
   **in that** the electrical contacts (5) are formed by bumps (6).

7. Semiconductor component according to one of the preceding claims,
   **characterized**
   **in that** the bumps (6) are small solder balls.

8. Semiconductor component according to one of Claims 1 to 6,
   **characterized**
   **in that** the bumps (6) are silicone bumps with electrical conducting areas (6a) lead over them for contact-making purposes or electrically conductive bumps essentially composed of silicone.

**EP 1 530 801 B1**

9. Semiconductor component according to one of the preceding claims in conjunction with a printed circuit board, **characterized in that** the material of the buffer layer (7) is chosen such that the thermal expansion coefficient of the buffer layer is greater than the thermal expansion coefficient of such printed circuit board material on which the semiconductor component (1) is to be fixed.

10. Semiconductor component according to one of the preceding claims, **characterized in that** the buffer layer (7) is highly elastic.

11. Semiconductor component according to one of Claims 9 or 10, if Claim 10 refers back to Claim 9, **characterized in that** the material of the housing (8) is chosen such that the thermal expansion coefficient of the housing is equal to that of such printed circuit board material on which the semiconductor component (1) is to be fixed.

12. Semiconductor component according to one of the preceding claims, **characterized in that** the material of the housing (8) is chosen such that the thermal expansion coefficient of the housing is greater than that of the semiconductor chip.

13. Semiconductor component according to one of the preceding claims, **characterized in that** the buffer layer (7) is composed of a polymer, in particular silicone or polyurethane.

14. Semiconductor component according to Claim 13, **characterized in that** the buffer layer (7) is composed of a foamed material.

**Revendications**

1. Composant à semi-conducteurs (1) pour le montage sur une carte à circuits imprimés, le composant à semi-conducteurs comportant une puce à semi-conducteurs (3) conçue plane, dans lequel des contacts électriques (5) sont associés à la puce à semi-conducteurs, contacts au moyen desquels une liaison électrique doit être établie avec des électrodes ou des surfaces d'électrodes prévues sur la carte à circuits imprimés, dans lequel la puce à semi-conducteurs plane (3) comporte une surface latérale de montage (33), une surface d'appui (31) étant agencée sur la surface latérale de montage (33), laquelle surface d'appui est sensiblement inférieure à la surface latérale de montage (33), et des surfaces de contact électriques (32) étant prévues à l'intérieur de la surface d'appui (31) sur la surface latérale de montage (33) pour le contact avec les contacts électriques (5), dans lequel le composant à semi-conducteurs (1) comporte un boîtier (8), dans lequel le composant à semi-conducteurs (1) comporte une couche tampon (7) entre le boîtier (8) et la puce à semi-conducteurs (3), **caractérisé en ce que** le boîtier (8) entoure complètement la puce à semi-conducteurs (3), **en ce que** la couche tampon (7) entoure la puce à semi-conducteurs (3) à part la zone de la surface d'appui (31) et **en ce qu'**un diamètre G de la couche tampon (7) entre le boîtier (8) et une surface latérale de la puce à semi-conducteur (3) est égal à

$$G := C \times (\alpha_F - \alpha_C) / (\alpha_G - \alpha_F)$$

G étant le diamètre de la couche tampon (7) entre le boîtier (8) et une surface latérale de la puce à semi-conducteur (3), C la longueur de la perpendiculaire allant de la surface latérale au centre de la puce à semi-conducteurs (3), $\alpha_C$ le coefficient de dilatation en température de la puce à semi-conducteurs (3), $\alpha_G$ le coefficient de dilatation en température de la couche tampon (7) et $\alpha_F$ le coefficient de dilatation en température du boîtier (8).

2. Composant à semi-conducteurs selon la revendication 1, **caractérisé en ce que** la puce à semi-conducteurs (3) s'appuie mécaniquement sur un socle d'appui (9), formé à partir du boîtier (8), sur la surface d'appui (31) agencée

8

sur la surface latérale de montage (33).

3. Composant à semi-conducteurs selon la revendication 1 ou 2, **caractérisé en ce que** la puce à semi-conducteurs (3) est assemblée de manière mécanique et fixe à un socle d'appui (9), formé à partir du boîtier (8), sur la surface d'appui (31) agencée sur la surface latérale de montage (33) et **en ce que** le socle sert au guidage d'amenées de lignes (91) des contacts électriques (5, 6, 61) aux surfaces de contact électriques (32).

4. Composant à semi-conducteurs selon l'une des revendications 1 à 3, **caractérisé en ce que** la surface d'appui (31) est agencée au centre dans la surface latérale de montage (33).

5. Composant à semi-conducteurs selon l'une des revendications 1 à 3, **caractérisé en ce que** la surface d'appui (31) est agencée au barycentre géométrique de la surface latérale de montage (33).

6. Composant à semi-conducteurs selon l'une des revendications précédentes, **caractérisé en ce que** les contacts électriques (5) sont formés par des bosses (6).

7. Composant à semi-conducteurs selon l'une des revendications précédentes, **caractérisé en ce que** les bosses (6) sont des billes soudées.

8. Composant à semi-conducteurs selon l'une des revendications 1 à 6, **caractérisé en ce que** les bosses (6) sont des billes de silicone avec des surfaces conductrices électriques (6a) guidées au-dessus pour la mise en contact ou des billes électriquement conductrices et constituées globalement de silicone.

9. Composant à semi-conducteurs selon l'une des revendications précédentes, en relation avec une carte à circuits imprimés, **caractérisé en ce que** le matériau de la couche tampon (7) est choisi de telle sorte que le coefficient de dilatation en température de la couche tampon est supérieur au coefficient de dilatation en température du matériau de carte à circuits imprimés sur lequel le composant à semi-conducteurs (1) doit être fixé.

10. Composant à semi-conducteurs selon l'une des revendications précédentes, **caractérisé en ce que** la couche tampon (7) est de grande élasticité.

11. Composant à semi-conducteurs selon l'une des revendications 9 ou 10, lorsque la revendication 10 est dépendante de la revendication 9, **caractérisé en ce que** le matériau du boîtier (8) est choisi de telle sorte que le coefficient de dilatation en température du boîtier est égal à celui du matériau de carte à circuits imprimés sur lequel le composant à semi-conducteurs (1) doit être fixé.

12. Composant à semi-conducteurs selon l'une des revendications précédentes, **caractérisé en ce que** le matériau du boîtier (8) est choisi de telle sorte que le coefficient de dilatation en température du boîtier est supérieur à celui de la puce à semi-conducteurs (3).

13. Composant à semi-conducteurs selon l'une des revendications précédentes, **caractérisé en ce que** la couche tampon (7) est en un polymère, notamment en silicone ou en polyuréthane.

14. Composant à semi-conducteurs selon la revendication 13, **caractérisé en ce que** la couche tampon (7) est en un matériau expansé.

**FIG 1**

**FIG 2**

**FIG 3**

## FIG 4

## FIG 5

## FIG 6

## FIG 7

$$\alpha_C := 3 * 10^{-6} \quad /K$$
$$\alpha_G := 300 * 10^{-6} \quad /K$$
$$\alpha_F := 16 * 10^{-6} \quad /K$$

$$G = 4,6\% * C$$

**EP 1 530 801 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2002034872 A1
- US 2002038890 A1
- JP 2001210760 A
- US 2002027298 A1

13